(19) Europäisches Patentamt
European Patent Office
Office européen des brevets

(11) **EP 3 142 146 A1**

(12) **EUROPEAN PATENT APPLICATION**

(43) Date of publication:
**15.03.2017 Bulletin 2017/11**

(51) Int Cl.:
*H01L 27/12* (2006.01)   *H03K 17/687* (2006.01)
*H03K 17/16* (2006.01)

(21) Application number: **15184391.9**

(22) Date of filing: **09.09.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Nokia Technologies Oy
02610 Espoo (FI)**

(72) Inventor: **NOHRA, George
San Jose, CA California 95134 (US)**

(74) Representative: **Nokia Corporation
Intellectual Property Department
Karakaari 7
02610 Espoo (FI)**

(54) **SILICON-ON-INSULTOR CHIP WITH IMPROVED HARMONICS AND LINEARITY, AND DESIGN METHOD THEREOF**

(57)     In one aspect a circuit including a switch transistor (101) and an auxiliary transistor (102) is disposed on an insulating layer. The switch transistor (101) includes a gate terminal (101G), a source terminal (101S), a drain terminal (101D) and a body terminal (101B). The auxiliary transistor (102) includes a gate terminal (102G), a source terminal (102S), and a drain terminal (102D). The body terminal (101B) of the switch transistor is coupled to one of the source terminal of the auxiliary transistor or the drain terminal (102D) of the auxiliary transistor, and the gate terminal (102G) of the auxiliary transistor is shorted to a low impedance node of the switch transistor. The source (101S) and the drain (101D) terminals of the switch transistor are specific examples of such a low impedance node of the switch transistor. Also described is a method of designing a circuit.

FIG. 1A

EP 3 142 146 A1

**Description**

TECHNOLOGICAL FIELD:

The described invention relates to integrated circuits and chips, and more particularly relates to body contacts for partially depleted silicon on insulator chips.

BACKGROUND:

Electronic chips of the silicon on insulator (SOI) variety in which the silicon junction is above the electrical insulator layer are subject to what is known as the floating body effect, whereby the body potential of a transistor exhibits 'history' effects in that over time it becomes dependent on the transistor's biasing. In practice the transistor's body forms a capacitor against the insulated substrate of the SOI chip, and some of the adverse effects of these accumulating charges include parasitic leakage. In a DRAM cell when the transistor's threshold voltage changes in dependence on its previous states it may lead to the loss of stored data.

Fully depleted CMOS devices (also known as bulk silicon CMOS) are less prone to this since the insulating layer is typically much thinner than the channel depletion width, enabling the charge and the body potential of the transistors to be fixed. But the above history effect problem remains in partially depleted (PD) SOI devices, which are becoming more ubiquitous. Particularly PD CMOS SOI chips are becoming a mainstay technology in the most advanced radio-frequency front-end architectures for mobile handsets and other mobile communication devices. This is due to PD CMOS SOI being more cost effective as compared to Gallium-Arsenide chips and other III-V technologies, as well as steady improvements in RF performance (e.g., via improvements in switching speed that largely close the gap as compared to fully depleted CMOS SOI) and its portability to large volume manufacturing such as via 300 mm wafers from which the individual chips are cut.

The distinction between fully-depleted and PD SOI are well known in the art; in general for a n-type PD SOI MOSFET the sandwiched p-type film between the gate oxide and the buried oxide (BOX) is large which prevents the depletion region from covering the whole p region, whereas the very thin in fully depleted SOI devices enables the depletion region to cover the whole film.

In the RF regime SOI is used in both linear and non-linear circuits such as switches, tuners and amplifiers. Traditionally the insulator in SOI is silicon dioxide but for high performance RF applications sapphire has also proven quite effective as the insulating material and these are more specifically known as silicon on sapphire. The similarities of PD-SOI to bulk CMOS means that PD-SOI inherently has leakage mechanisms that compromise its RF performance. For example, Gate Induced Drain Lowering (GIDL) current introduces signal harmonics which compromises linearity (e.g., IIP3).

In addition to GIDL, the non-linear 'OFF-state' capacitance is another source of harmonic generation. Second harmonic as well as inter-modulation distortion (IMD) generation depends on the way an SOI device is biased in its 'ON-state'.

Adding a body contact to SOI CMOS devices addresses the above floating body effect which conventionally improves harmonic performance for a switch's 'OFF-state'. But at the same time these conventional body contacts also create a leakage path when the switch arm is in its 'ON-state', resulting in at least even-order harmonics (e.g., 2nd harmonic) and IMD being generated by the bias point of the device's 'ON-state'. The 2nd harmonic generation can be mitigated by external notch filters which have recently been incorporated into antenna switch modules for this purpose, but this is a cumbersome and expensive approach.

Some relevant background can be seen at: US Patent Application Publication No. 2015/0015321 (*Circuit and Method for Controlling Charge Injection in Radio Frequency Switches,* by Dribinsky et al.); US Patent No. 8,829,967 (*Body-Contacted Partially Depleted Silicon On Insulator Transistor,* by Nohra, the inventor herein); US Patent No. 8,129,787 (*A Method and Apparatus for Use in Improving the Linearity Characteristics of MOSFET Devices Using an Accumulated Charge Sink*, by Brindle et al.); and US Patent No. 8,954,902 (*Method and Apparatus Improving Gate Oxide Reliability by Controlling Accumulated Charge*, by Stuber et al.); each of which is hereby incorporated by reference.

Improvements in 2nd harmonic performance is critical in general for cost-effective silicon-based technologies (e.g., PD-SOI) to displace traditional (more expensive) III-V based switch technologies (e.g., GaAs). More particularly, improvements in 2nd harmonic performance and in IMD in general for all switch technologies that are specific for use in dual-carrier radio systems (e.g., 4G LTE-A) is necessary given that IIP3 requirements in excess of +70dBm have been widely accepted. Embodiments of these teachings contribute such improvements to SOI devices as will be shown below via non-limiting examples of PD-SOI devices.

SUMMARY:

According to one aspect of these teachings there is a circuit disposed on an insulating layer. The circuit comprises a switch transistor and an auxiliary transistor. The switch transistor comprises a gate terminal, a source terminal, a drain terminal and a body terminal. The auxiliary transistor comprises a gate terminal, a source terminal, and a drain terminal. The body terminal of the switch transistor is coupled to one of the source terminal of the auxiliary transistor or the drain terminal of the auxiliary transistor, while and the gate terminal of the auxiliary transistor is shorted to a low impedance node of the switch transistor. The source and the drain terminals of the switch transistor are specific examples of such a low impedance node of the switch transistor.

In another aspect of these teachings there is a method of designing a circuit, and in this aspect the method comprises a) determining a maximum harmonic distortion over a prescribed range of input voltages; b) for a circuit comprising a switch transistor and an auxiliary transistor in which a body terminal of the switch transistor is coupled to a source terminal of the auxiliary transistor or a drain terminal of the auxiliary transistor, designing an impedance to couple a gate terminal of the auxiliary transistor to a source terminal of the switch transistor or a drain terminal of the switch transistor such that for any input voltage within the prescribed range, output voltage from the switch transistor does not exceed the determined maximum harmonic distortion; and c) implementing the circuit with the designed impedance in at least one of a circuit diagram or a silicon-on-insulator chip.

In a further aspect of these teachings there is a circuit comprising a switch transistor and an auxiliary transistor. The switch transistor has a gate terminal, a source terminal, a drain terminal and a body terminal. The auxiliary transistor has a gate terminal, a source terminal, and a drain terminal. The body terminal of the switch transistor is coupled to one of the source terminal of the auxiliary transistor or the drain terminal of the auxiliary transistor. The gate terminal of the auxiliary transistor is coupled to a node of the switch transistor, and this coupling/connection is such that an impedance coupling the gate terminal of the auxiliary transistor to the source terminal of the switch transistor or the drain terminal of the switch transistor yields, for any input voltage within a prescribed range, an output voltage from the switch transistor that is within an allowed maximum harmonic distortion.

These and other aspects of these teachings are detailed further below with particularity.

BRIEF DESCRIPTION OF THE DRAWINGS:

FIGs. 1A-1C are circuit diagrams of a body contact circuit according to certain non-limiting aspects of these teachings.

FIG. 2 is a circuit diagram of a prior art body contact circuit taken from US Patent No. 8,829,967.

FIG. 3 is a circuit diagram of a test circuit that was used to obtain simulation results presented herein for quantitatively comparing the circuits of FIG. 1A and FIG. 2.

FIG. 4 is a data plot of second order trans-conductance comparing the circuits of FIG. 1A and FIG. 2.

FIG. 5 is a data plot of GIDL comparing the circuits of FIG. 1A and FIG. 2.

FIG. 6 is a data plot of gate-to-source capacitance comparing the circuits of FIG. 1A and FIG. 2.

FIG. 7 is a circuit diagram showing four pairs of body contact circuits, each circuit similar to that of FIG. 1 and each pair sharing gate voltage in parallel and also source/drain voltages in series, disposed as a transmit/receive switching arrangement in a radio front end chip according to an exemplary embodiment of these teachings.

FIG. 8 is a high level schematic block diagram of some exemplary communication entities in which embodiments of these teachings may be disposed to exploit the advantages thereof.

DETAILED DESCRIPTION:

Embodiments of these teachings concern improvements to an SOI switch in both the 'OFF' and 'ON' states in terms of switch linearity. The examples herein focus on improvements in SOI used in cellular mobile systems such as RF front end chips but these improvements are widely applicable to other switch-based applications. PD-SOI is assumed for the examples below due to the fact that the floating body effect is more difficult to address in PD devices and PD-SOI is becoming more important for RF applications, but these teachings are also applicable for FD-SOI chips and devices. Further, the examples assume the switch is a MOSFET but this also is non-limiting as other types of four-terminal FETs can be improved by these teachings. In general the switch FETs shown in the drawings are defined by a source (S), gate (G), drain (D), and body (B) terminals, all of which are conventionally illustrated. Often the body (or substrate) of a MOSFET is connected (internally shorted) to the source terminal making it in effect a three-terminal FET. In these teachings the body terminal is connected to the source or drain of an auxiliary device, hence the term body contact. In this regard switching transistors/FETs having an internally shorted body terminal are not particularly relevant to these teachings.

The example embodiments below present body contact (BC) circuits which provide several advantages over conventional body contact circuits, including improvements in 3rd harmonic generation as well as in 2nd harmonics and IMD, better blocking of leakage when the device is in the ON state, and also improved switch ruggedness. The harmonic improvements arise primarily from reduced leakage, a more linear parasitic capacitance, and a lower transconductance Gm2. As will be shown quantitatively below, the example body contact circuits described herein improve the 2nd order harmonic generation by up to 8 dB as well as IMDs and with minimal complexity, and without addition of a notch filter as mentioned in the background section above which add complexity to the mobile phone circuit board.

The non-limiting embodiments described herein are directed to deployments of these teachings in a switch capacity, which more fully exploit advantages these teachings enable in GIDL and non-linear junction capacitances as detailed further below. Other embodiments may find these teachings deployed as memory devices in SOI memory chips, for example DRAM chips.

To better appreciate the specific embodiments detailed below, it is important to realize that RF switches are recognized as essential building blocks that are utilized in wide variety of what are commonly referred to as radio front end modules or RF front end chips, as well as other communication systems including cellular/portable devices, satellites and navigation systems. Linearity or power handling is a critical specification for most of these switches and is especially critical for those used in these front end modules such as antenna switch modules and transmit modules. In order to achieve good power handling up to 40 dBm under a worst case antenna mismatch, the choice of technology becomes critical. It is for this reason that the latest developments in SOI technologies have proven so effective for RF uses as they achieve a 'sweet spot' in the combination of performance, cost and integration.

Practical considerations require that SOI-based front end switches need to be carefully designed for large signal performance, and linearity and distortion are the most important specifications in need of improvement. In recent past years there was more focus on improving the third harmonics since it was more impacted by large GSM signal, primarily due to the Off Arms reflected third harmonics. As such there has been appreciable improvement to SOI switch third harmonics. But the new fourth and fifth generation LTE specifications (e.g., LTE-A) are calling for much lower second harmonics levels and this is one aspect in which embodiments of these teachings provide significant advantages over the known art, to the point these teachings may supplant expensive and bulky external LC harmonic notch filters for improving the second harmonics. As mentioned above, LC notches are not the ideal solution for RF deployments and the SOI body contact embodiments herein have the potential to provide a cheaper circuit solution.

The AC component of drain source current is:

$$i_{ac} = \left( \frac{k_n}{1 + v_{ds}/LE_c} \right) \left( \frac{W}{L} \right) v_{ds} \left( V_{GS} + v_{gs} - V_T - 0.5 v_{ds} \right), \qquad \text{(eq. 1)}$$

where Ec is the mobility critical electric field, $k_n$ is the process transconductance parameter (equal to $\mu_n * C_{ox}$) and AC components are expressed in lower case.

The CMOS I/V relation can be expressed using a Taylor series expansion as follow:

$$I_{DS} = \sum_{n=1}^{\infty} \propto_n V_{DS}^N. \qquad \text{(eq. 2)}$$

The first two $\propto_n$ are determined to be:

$$\propto_1 = k_n \frac{w}{L} (V_{GS} - V_T), \qquad \text{(eq. 3)}$$

$$\propto_2 = k_n \frac{w}{L} \left( \frac{v_{gs}}{v_{ds}} - \frac{V_{GS}-V_T}{LE_C} \right),$$  (eq. 4)

and

$$\frac{v_{gs}}{v_{ds}} = - \frac{\frac{Z_0}{R_S} - jwR_G C_{DG}}{1 + jwR_G(C_{DG}+C_{GS})};$$  (eq. 5)

where $R_S$ is the switch ON-state resistance (which is mostly channel resistance),
$R_G$ is the resistor attached in series with the transistor gate, and
$Z_0 = 50$ *Ohms*.

IIP2 of the switch can be derived as:

$$IIP2 = \frac{Z_0}{2R_S^4 \propto_2^2} \left( 1 + \frac{2Z_0}{R_S} \right)^2.$$  (eq. 6)

Equations (1) to (6) above suggest four main conclusions:

1- Large voltage across $C_{GS}$ will degrade the second harmonics, therefore reducing $v_{gs}$ will improve both H2 and IM2. Also $C_{GS}$ needs to be linear over power for better linearity and harmonics.
2- Increasing $v_{ds}$ or reducing *vsat* will improve second order harmonics H2 and second order intermodulation distortion IM2.
3- Reducing *Rs* (or increasing $g_{meff}$ per W) should improve H2 and IM2.
4- Reducing second order trans-conductance $g_{m2}$ will improve H2 and IM2.

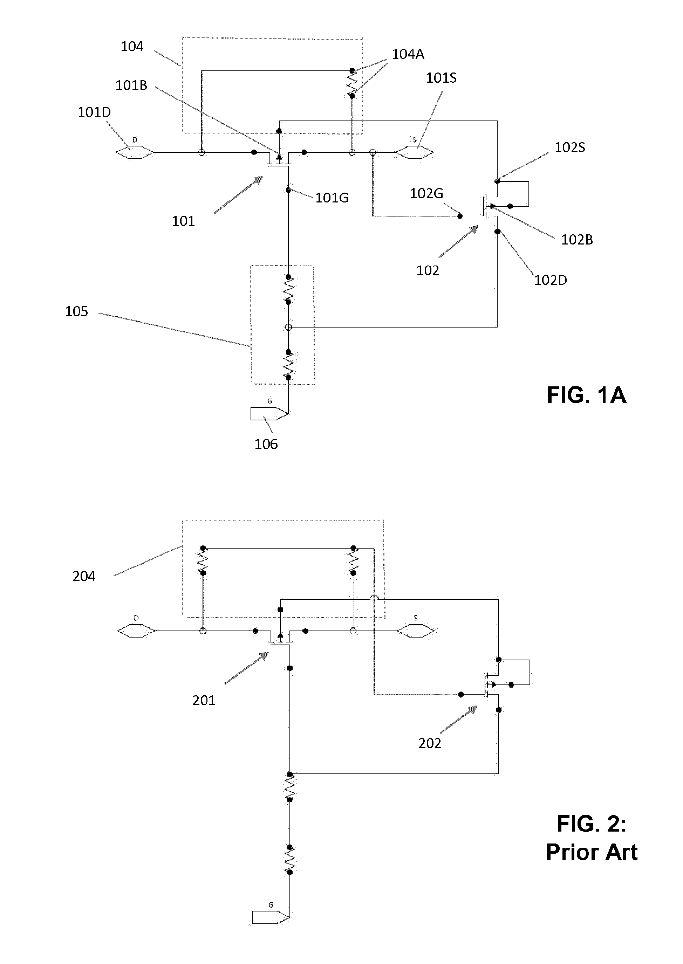

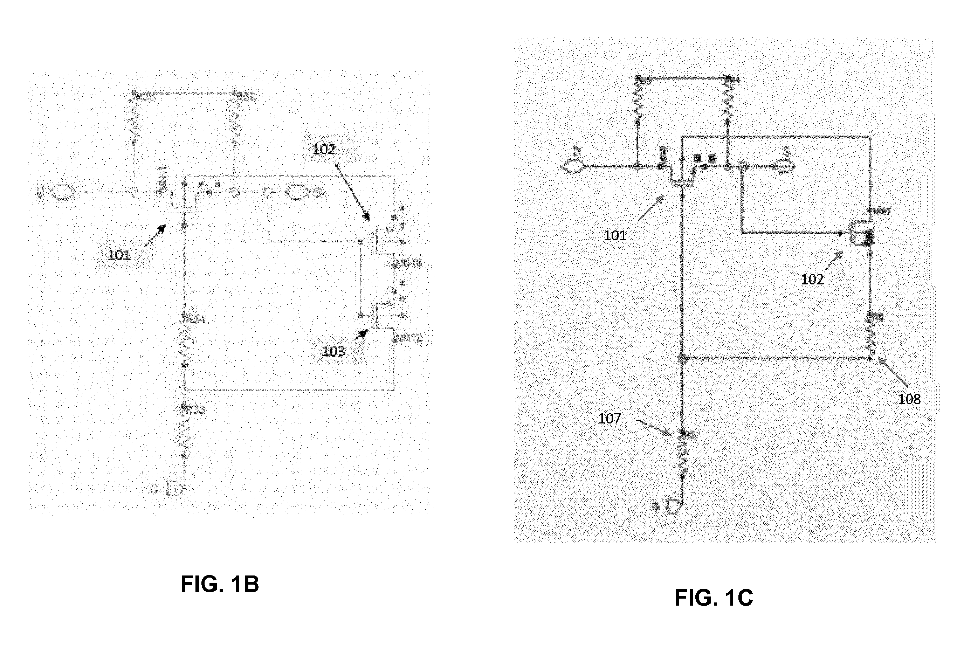

The body contact circuits of the examples herein are shown by quantitative test data presented below to improve one or more of the above four elements. FIGs. 1A-1C show three such exemplary body contact circuits. In each of these FIGs there is a switch transistor 101 and an auxiliary transistor 102. The switch transistor 101 has a gate terminal 101 G, a source terminal 101S, a drain terminal 101D and a body terminal 101B. The switch transistor 101 may also be referred to as a main transistor or a primary transistor. Similarly, the auxiliary transistor 102 has a gate terminal 102G, a source terminal 102S, a drain terminal 102D and a body terminal 102B. The auxiliary transistor 102 may also be referred to as a discharge transistor or a body contact transistor. For clarity of illustration these various terminals are specifically designated by reference numbers only in FIG. 1A but they are similarly situated in FIGs. 1B and 1C (except the source and drain of the auxiliary transistor are reversed at FIG. 1C), which illustrate the FETs conventionally. While the auxiliary transistor 102 is shown as a four-terminal device with the body terminal 102B internally shorted to either the source 102S or drain 102D terminals, in other embodiments the auxiliary transistor 102 may be implemented as a three-terminal device which lacks any body terminal.

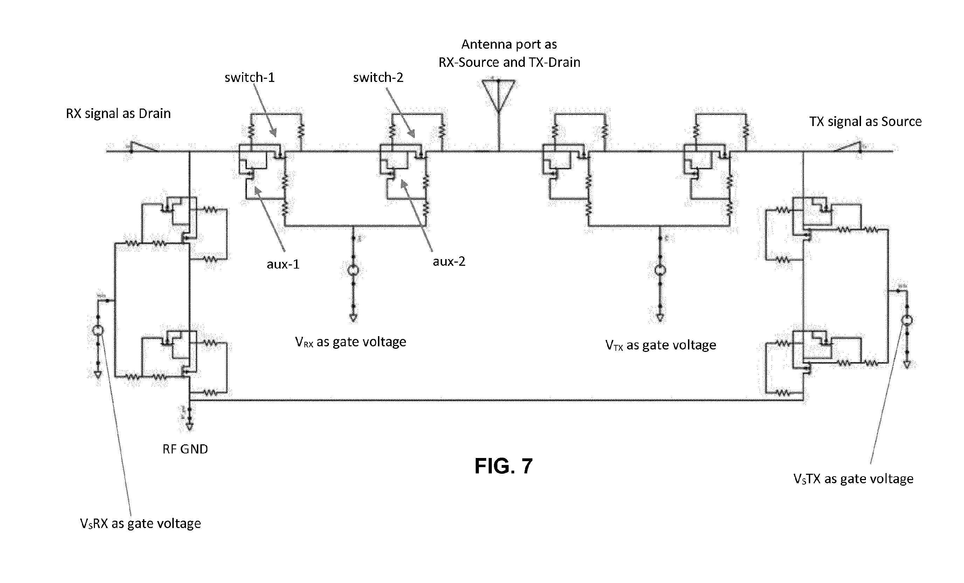

Each of FIGs. 1A-1C also has a resistance network 104 coupling the source 101S and drain 101D terminals to one another apart from the gate terminal 101G. The nodes 104A of the switch transistor 101 shown in FIG 1A are considered to be high impedance nodes since they couple to the respective source 101S or drain 101D terminals of the switch resistor 101 through an active resistance (the illustrated resistor) as opposed to mere passive resistance that is inherent in a conductive trace. In other embodiments such as the circuits shown at FIGs. 1B-C and FIG. 7 there may be one or more additional mid-mode resistors within the resistance network 104.

In each of FIGs. 1A-1C the body terminal 101B of the switch transistor 101 is coupled to the source terminal 102S of the auxiliary transistor 102. In other embodiments the body terminal 101B of the switch transistor 101 is coupled to the drain terminal 102D of the auxiliary transistor 102. In the specific embodiments shown in FIGs. 1A-1C the body terminal 101B of the switch transistor 101 is shorted to the source terminal 102S of the auxiliary transistor 102, and similarly in other embodiments the body terminal 101 B of the switch transistor 101 may be shorted to the drain terminal 102D of the auxiliary transistor 102.

Additionally, in each of FIGs. 1A-1C the gate terminal 102G of the auxiliary transistor 102 is shorted to the source terminal 101S of the switch transistor 101. In other embodiments the gate terminal 102G of the auxiliary transistor 102 is shorted to the drain terminal 101D of the switch transistor 101.

The source and drain terminals of the respective switch and auxiliary transistors are themselves low impedance nodes of these respective transistors. In more general terms the body terminal 101B of the switch transistor 101 is coupled to a low impedance node of the auxiliary transistor 102, while the gate terminal 102G of the auxiliary transistor 102 is coupled to a low impedance node of the switch transistor 101. In the illustrated embodiments both of these couplings are shorts since the relevant nodes of the respective transistors are the source or drain terminals themselves.

Specific for FIG. 1A, there is another resistance network 105 between the gate node 106 and the gate terminal 101 G of the switch transistor 101, specifically two resistors in series. The gate node 106 is the point at which voltage from external of the switch terminal 101 is applied, and so the voltage seen by the gate terminal 101G is reduced by the resistance R of this resistance network 105 as compared to the voltage applied to the gate node 106. While two resistors in series are shown for this resistance network 105 there may be any number of resistors in series. At the embodiment of FIG. 1A the drain terminal 102D of the auxiliary transistor 102 is coupled to the gate terminal 101G of the switch transistor 101 via at least one but fewer than all of the discrete resistances on the resistance network 105. In other embodiments in which the body terminal 101B of the switch transistor 101 is coupled to the drain terminal 102D of the auxiliary transistor 102, then it would be the source terminal 102S of the auxiliary transistor 102 which is coupled to the gate terminal 101G of the switch transistor 101 via at least one but fewer than all of the discrete resistances on the resistance network 105.

The embodiment of FIG. 1B is similar to that of FIG. 1A with one significant exception: what was a singular auxiliary transistor 102 is now a plurality of auxiliary transistors 102, 103 in FIG. 1B. While two auxiliary transistors 102, 103 are shown there may be more than two, but however many the FIG. 1B embodiment has these auxiliary transistors 102, 103 in series with one another and having respective gate terminals shorted to one another. The specific terminals are not separately annotated in Fig. 1B but each auxiliary transistor is situated as shown in FIG. 1B for the singular auxiliary transistor 102; and in alternative embodiments they may be reversed in that their respective source and drain terminals are opposite what is shown at FIG. 1B.

Cascading auxiliary transistors 102, 103 while shorting their gates to the source 101S or drain 101D of the switching transistor 101 as shown in the FIG. 1B example improves the second harmonics and IM2 even more than the FIG. 1A embodiment, and additionally improves the voltage handling of the auxiliary side of the circuit.

The embodiment of FIG. 1C differs from that of FIG. 1A in two respects. Firstly, the source 102S and drain 102D terminals of the auxiliary transistor 102 are reversed as compared to FIG. 1A so that in FIG. 1C it is the drain terminal 102D of the auxiliary device 102 that is shorted to the body terminal 101B of the switch device 101. Secondly, there are first 107 and second 108 resistors in parallel to one another in FIG. 1C, and disposed such that the first resistor 107 couples the gate terminal 101G of the switch transistor 101 to a gate node 106 of the circuit, while the second resistor 108 couples the gate terminal 101G of the switch transistor 101 to the source terminal 102S of the auxiliary transistor 102. Or stated more generally the second resistor 108 couples the gate terminal 101G to whichever of the source terminal 102S or the drain terminal 102D of the auxiliary transistor 102 that is not shorted to the body terminal 101B of the switch transistor 101.

As mentioned above, these examples assume a PD-SOI chip but are not limited thereto. In general FD SOI defines an insulating layer at maximum of about 30 nm, while traditionally PD SOI used a BOX layer of about 145 nm. The divide between PD and FD is not so stark that one specific layer thickness categorically defines one over the other and so for purposes of these teachings a deployment of the circuits described by example herein disposed over an insulating layer defining a minimum thickness of about 80 nm (+/- 5 nm) is considered PD SOI while thinner insulation layers may be considered as more within the FD SOI regime. Conventionally for PD SOI the insulating layer is oxide buried in the silicon underlay to form silicon dioxide, but particularly for RF applications sapphire (a form of aluminum oxide with certain impurities) has been shown to facilitate increased switching speeds.

Embodiments of these teachings can be deployed to significant advantage in a PD SOI chip within a mobile radio device such as a smartphone or more generally what 3GPP terms a user equipment (UE), and particularly where the chip is a RF front end chip, whether alone or disposed within a multi-chip RF front end module. FIG. 7 illustrates one non-limiting deployment within an RF chip as a transmit/receive switch for one antenna port.

To the inventor's knowledge the nearest body contact circuit to those described herein is shown at FIG. 2, from the inventor's prior work at US Patent No. 8,829,967. In the body contact circuit of FIG. 2 the gate of the auxiliary transistor 202 is coupled to a high impedance node of the switch transistor 201 while the drain of the auxiliary transistor 202 is shorted to the gate of the switch transistor 201. In the FIG. 2 circuit the resistance network 204 operates to ac decouple (by $R_{DS}$) the gate of the auxiliary transistor 202 from the source of the switch transistor 201.

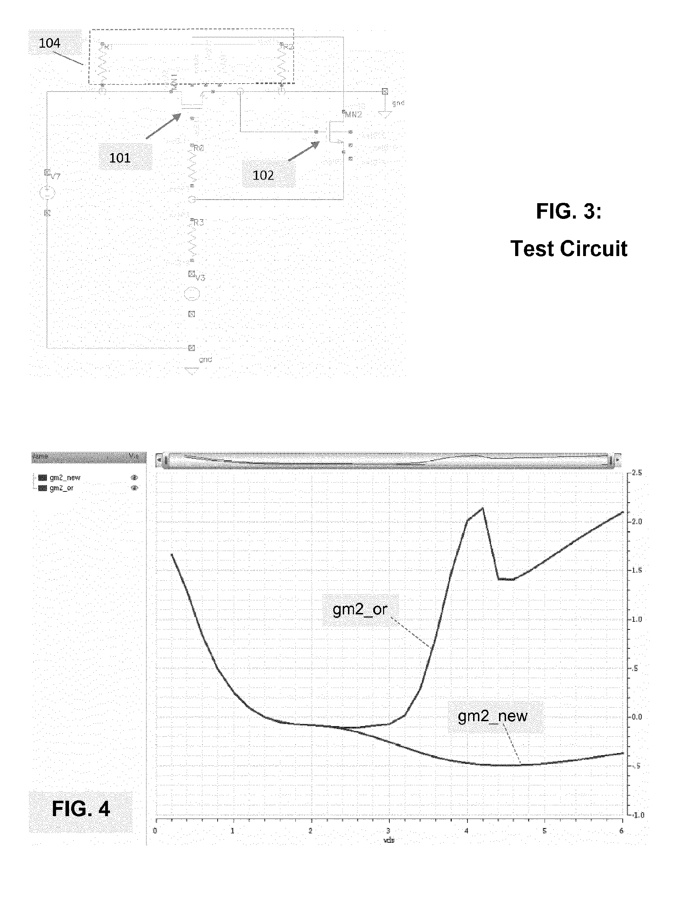

The circuit of FIG. 1A was tested against that of FIG. 2 in order to quantify the improvements herein. In order to emulate large signal simulation and compare the FIG. 1A circuit versus the FIG. 2 circuit, a DC voltage $V_{DS}$ sweep was applied to the Drain of the switch FET of both circuits; at the same time, half of $V_{DS}$ is swept to the gate of the switch FET on top of the constant gate bias $\{V3 = (V_G + V^{DS}/_2)\}$. FIG. 3 shows the test circuit used, in which V7= $V_{DS}$. Sweeping $V_{DS}$ enables monitoring of how the switch bias point behaves under a very large signal sweep.

When compared to the BC circuit of FIG. 2, the circuit of FIG. 1A showed lower $g_{m2}$ over the swept $V_{DS}$ as shown in FIG. 4 which plots simulation results for second order trans-conductance, where the plotline marked as $gm2\_or$ for the FIG. 2 circuit spikes higher with increasing $V_{DS}$ and the plotline marked as $gm2\_new$ for the FIG. 1A circuit trends smoothly lower with increasing $V_{DS}$.

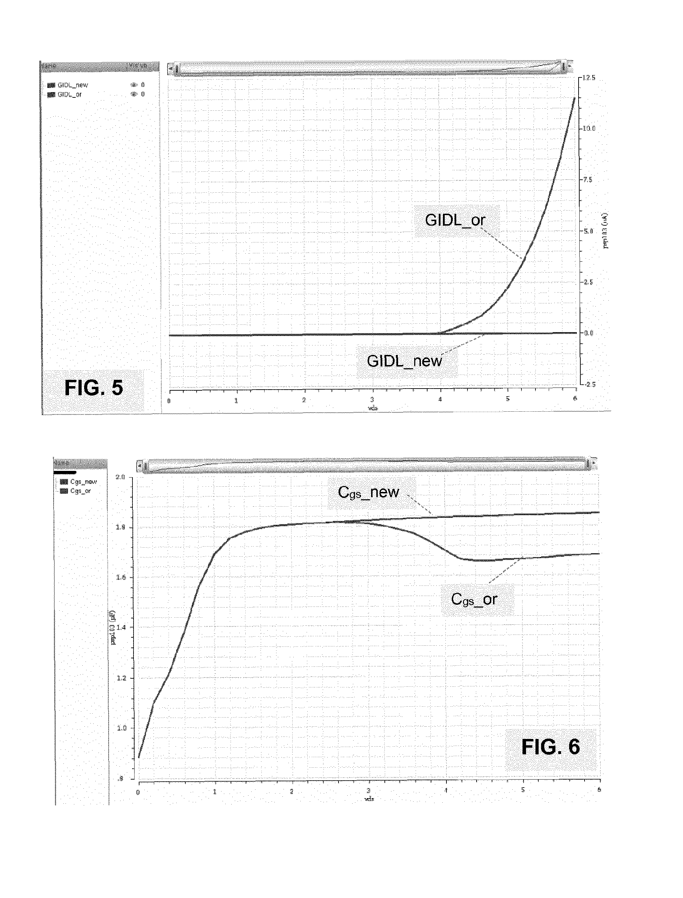

Gate-induced drain lowering (GIDL) current is another metric for harmonics; generally a lower level GIDL current translates to better harmonics. Simulation results comparing GIDL for the circuit of FIG. 1A as compared to that of FIG. 2 are plotted at FIG. 5, and reveal that the BC circuit which is plotted as *GIDL_new* at FIG. 1A has a lower GIDL current as compared to the circuit of FIG. 2 which is plotted as *GIDL_or* and spikes to a significantly higher GIDL with increasing $V_{ds}$.

FIG. 6 plots simulation results comparing gate-to-source capacitance ($C_{GS}$; also termed as gate-to-drain capacitance) of the FIG. 1A circuit versus that of the FIG. 2 circuit; the plotline marked $C_{gs\_}new$ reflects Fig. 1A and the plotline marked $C_{gs\_}or$ reflects FIG. 2. While the two circuits exhibit similar *Cgs* at the left side of FIG. 6, above about $V_{ds}$=2.5 the plotline for the circuit of FIG. 1A is significantly more linear.

Now having understood the circuit itself and its quantified advantages, FIG. 7 illustrates how multiple instances of such a circuit might be deployed in a RF front end chip, sometimes also referred to as an antenna chip or antenna switch module. Specifically, there are eight instances in FIG. 7 of the same circuit shown at FIG. 1A (but with two discrete resistances in the resistance circuit 104 rather than one) deployed in pairs with the switch transistors having parallel gate voltages and series source-drain terminals such that the source or drain of one switch transistor is coupled to the respective drain or source of its series-adjacent switch transistor.

At the center of FIG. 7 is an antenna port; the two pairs of circuits to its left switch a receive signal from the antenna port further into the RF chip on which FIG. 7 is a part, and the two pairs of circuits to its right switch a transmit signal from further into the RF chip to the antenna port. In this regard the antenna port acts as source for a wireless RF signal it receives and the FIG. 7 circuitry drains it to the left towards the annotated *RF signal as drain*, and an RF signal to be transmitted arrives from the annotated *TX signal as source* and the FIG. 7 circuitry drains it to the antenna port which then acts as drain. Each of the four pairs of circuits are identical, with one pair annotated with switch-1 and switch-2 which are in the position of the switch transistor 101 of FIG. 1, and aux-1 and aux-2 in the position of the auxiliary transistor 102 of FIG. 1.

On the receive side of FIG. 7 the annotated pair of circuits are line circuits and use receive voltage $V_{RX}$ as the gate voltage, and the remaining circuit pair are ground voltages which are coupled to RF ground and use $V_S RX$ as their gate voltage, all as shown. The transmit side to the right of the antenna port is similar; the line circuit pairs use transmit voltage $V_{TX}$ as their gate voltage, and the remaining circuit pair are also ground voltages and use $V_S TX$ as their gate voltage.

When a signal for transmission is present $V_{TX}$ is high which closes the gates at all four of the transmit-side circuits, coupling the TX signal to the antenna port with a valid ground. At the same time $V_{RX}$ is low which opens the gates at all four of the receive-side circuits, de-coupling the RX signal line from the antenna port and denying it a ground. The opposite occurs when there is a receive signal present at the antenna port when $V_{RX}$ is high and $V_{TX}$ is low. Certainly a full RF front end chip may employ many more than the eight instances of a body contact circuit according to these teachings as FIG. 7 show, but for the simple switching a single antenna port between TX and RX receive signals these embodiments improve 2nd and 3rd order harmonics as detailed above as well as reduce current leakage.

Generally for a transistor, harmonic distortion can be expressed by the equation

$$V_{OUT} = AV_{in} + BV_{in}^2 + CV_{in}^3 + ... ;$$

in which $V_{OUT}$ is the output/drain voltage from the transistor, $V_{in}$ is the input/source voltage to it, and A, B, C, etc. are constants specific to the given transistor and are non-zero unless the transistor is perfectly linear. The term $BV_{in}^2$ represents the second harmonic or second order distortion and the term $CV_{in}^3$ represents the third harmonic or third order distortion. Thus with increasing signal levels (increasing transmit or receive power) the second order component in the output signal will increase much faster than the fundamental component, and the third order component will increase even faster still. Generally we try to use transistors with very low constants A, B, C etc., but as noted above linearity in SOI chips for RF-type deployments is an increasingly difficult challenge for future radio access technologies now being developed

When designing an antenna switching module the designer first needs to know the maximum harmonic distortion over a prescribed range of input voltages; generally the radio access technology specifications will give this though often indirectly, for example as a maximum allowable deviation from transmit power prescribed by the network in whatever power control loop it employs with the mobile radio device. Now assuming a circuit according to these teachings such as those shown in the accompanying drawings, there will be a switch transistor and an auxiliary transistor in which a body terminal of the switch transistor is coupled to a source or drain terminal of the auxiliary transistor. The designer's task is then to design an impedance to couple the gate terminal of the auxiliary transistor to the source or drain terminal of the switch transistor such that for any input voltage to the switch transistor within the prescribed range, output voltage from the switch transistor will not exceed the determined maximum harmonic distortion. The designer may implement such a circuit with the designed impedance in a circuit diagram which s/he may then provide to a foundry or other chip manufacturer, or of course the designer may implement it as a physical silicon-on-insulator chip.

In the specific embodiments above the designed impedance was a shorted connection between the gate terminal of the auxiliary transistor and the source or drain terminal of the switch transistor. But that shorted connection is a non-limiting embodiment; the designer may choose to impose some active resistance along that connection which still allows the circuit to satisfy the maximum harmonic distortion, but which better optimizes some engineering tradeoff for some other parameter in the overall antenna switch or radio itself.

The prescribed range of input voltages may be a predefined range of at least one of transmit voltage $V_{TX}$ and receive voltage $V_{RX}$ for a radio; and the maximum harmonic distortion over the prescribed range of gate voltages may be what is required for a radio, in which the circuit is implemented within an antenna switch thereof, to comply with specifications of a radio access technology such as LTE-A or 5G for example. Further to the harmonic distortion equation above, the maximum harmonic distortion may include second order harmonic distortion and third order harmonic distortion.

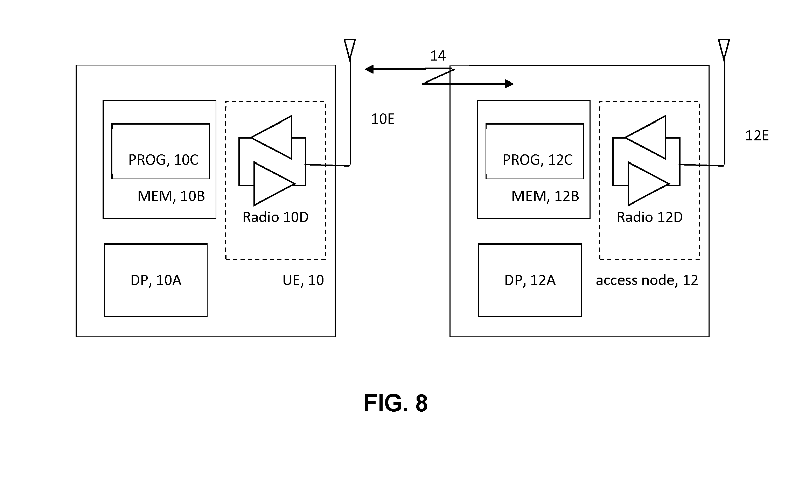

FIG 8 is a high level diagram illustrating some components of different communication entities on opposite side of the conventional uplink/downlink wireless divide in a generic radio communications network. The access node 12 corresponds to the entity of the radio access network that sends control signaling and data downlink to the mobile users, which are represented by the user equipment UE 10 which sends control information and data uplink to the radio access network via the access node 12. The access node 12 may be embodied as a cellular base station, NodeB, eNodeB, access point, relay node or remote radio head for example; while the UE 10 may be embodied as a handheld mobile radio device such as a smartphone, or a wearable or implantable version thereof. The radio access network may include a network control element (NCE, not shown) that may include mobility management entity/serving gateway functionality to provide connectivity with another network such as a publicly switched telephone network and/or a data communications network (e.g., the internet).

The UE 10 includes a controller, such as a computer or a data processor (DP) 10A, a computer-readable memory medium embodied as a memory (MEM) 10B that stores a program of computer instructions (PROG) 10C, and a suitable wireless interface such as radio 10D (shown as a transmitter and receiver) for bidirectional wireless communications with the access node 12 via one or more antennas 10E.

Similarly the access node 12 also includes a controller, such as a computer or a data processor (DP) 12A, a computer-readable memory medium embodied as a memory (MEM) 12B that stores a program of computer instructions (PROG) 12C, and a suitable wireless interface such as a radio 12D (shown as a transmitter and receiver) for bidirectional wireless communications with the UE 10 via one or more antennas 12E. The access node 12 may be coupled via a data/control path to the NCE (not shown) as well as to other access nodes via similar peer data/control paths.

At least one of the PROGs 10C, 12C is assumed to include program instructions that, when executed by the associated DP, enable the device to operate in accordance with the relevant communications protocol, and may comprise computer software executable by the DP 10A of the UE 10; and by the DP 12A of the access node 12, or by hardware, or by a combination of software and hardware (and firmware).

The UE 10 and/or the access node 12 may also include dedicated processors, for example in the radio 10D/12D or elsewhere. Such dedicated modules may be constructed so as to embody aspects of the invention as detailed herein. That is, embodiments of the circuits shown by example and more generally described herein may be disposed in the illustrated DPs 10A/12A, or in dedicated modules or chips such as a RF front end chip/module that forms part of the illustrated radios 10D/12D, and particularly the transmitter portion of such radios 10D/12D.

The DPs 10A and 12A, and any dedicated processing chips implementing these teachings, may be of any type of circuitry comprising interconnected logical gates that is/are suitable to the local technical environment, and may include one or more of general purpose computers, special purpose computers, microprocessors, digital signal processors (DSPs) and processors based on a multicore processor architecture, as non-limiting examples. The wireless interfaces (e.g., radios 10D and 12D) may be of any type suitable to the local technical environment and may be implemented using any suitable communication technology such as individual transmitters, receivers, transceivers or a combination of such components.

In general, the various embodiments of the UE 10 can include, but are not limited to, smart phones whether handheld, wearable on the body or implantable in whole or in part within the user's body; other types of cellular telephones including those fixedly or removably disposed in vehicles such as automobiles and watercraft; personal digital assistants (PDAs) having wireless communication capabilities; portable computers having wireless communication capabilities including laptops, palmtops, tablets and e-readers; image capture devices such as digital cameras having wireless communication capabilities; gaming devices having wireless communication capabilities; music storage and playback appliances having wireless communication capabilities; Internet appliances permitting wireless Internet access and browsing; as well as portable units or terminals that incorporate combinations of such functions.

The computer readable MEMs 10B and 12B may be of any type suitable to the local technical environment and may be implemented using any suitable data storage technology, such as semiconductor based memory devices, flash memory, magnetic memory devices and systems, optical memory devices and systems, fixed memory and removable memory. Any combination of one or more computer readable medium(s) may be utilized as a memory 10B/12B. The computer readable medium may be a computer readable signal medium or a non-transitory computer readable storage medium. A non-transitory computer readable storage medium does not include propagating signals and may be, for example, but not limited to: an electronic, magnetic, optical, electromagnetic, infrared, or semiconductor system, apparatus, or device; or any suitable combination of the foregoing. A more specific but non-exhaustive list of examples for the computer readable storage medium include: a portable computer diskette, a hard disk, a random access memory (RAM), a read-only memory (ROM), an erasable programmable read-only memory (EPROM or Flash memory), an optical fiber, a portable compact disc read-only memory (CD-ROM), an optical storage device, a magnetic storage device, or any suitable combination of the foregoing.

It should be understood that the foregoing description is only illustrative. Various alternatives and modifications can be devised by those skilled in the art. For example, features recited in the various dependent claims could be combined with each other in any suitable combination(s). In addition, features from different embodiments described above could be selectively combined into a new embodiment. Accordingly, the description is intended to embrace all such alternatives, modifications and variances which fall within the scope of the appended claims.

Acronyms used herein:

| | |
|---|---|
| 3GPP | Third Generation Partnership Project |
| AC | alternating current |
| BC | body contact |
| BOX | buried oxide |
| $C_{GS}$ | gate-to-source capacitance |
| CMOS | complementary metal oxide semiconductor |
| DRAM | dynamic random access memory |
| FD | fully depleted |
| FET | field effect transistor |
| GIDL | Gate-Induced Drain Lowering |
| GSM | Global System for Mobile communications |
| H2 / H3 | second order harmonics / third order harmonics |
| IMD / IM2 | inter-modulation distortion / second order IMD |
| LC | inductor-capacitor circuit |
| LTE-A | Long Term Evolution-Advanced (a 3GPP radio access technology) |
| MOSFET | metal oxide semiconductor FET |
| PD | partially depleted |
| RF | radio frequency |
| SOI | silicon-on-insulator |

**Claims**

1.  A circuit disposed on an insulating layer, the circuit comprising:

> a switch transistor having a gate terminal, a source terminal, a drain terminal and a body terminal; and
> an auxiliary transistor having a gate terminal, a source terminal, and a drain terminal;
> wherein

> the body terminal of the switch transistor is coupled to one of the source terminal of the auxiliary transistor or the drain terminal of the auxiliary transistor; and the gate terminal of the auxiliary transistor is shorted to a low impedance node of the switch transistor.

2.  The circuit according to claim 1, wherein the source terminal of the switch transistor is the low impedance node of the switch transistor to which the gate terminal of the auxiliary transistor is shorted.

3.  The circuit according to claim 1, wherein the drain terminal of the switch transistor is the low impedance node of the switch transistor to which the gate terminal of the auxiliary transistor is shorted.

4. The circuit according to any of claims 1-3, wherein the body terminal of the switch transistor is shorted to either the source terminal of the auxiliary transistor or the drain terminal of the auxiliary transistor.

5. The circuit according to any of claims 1-4, wherein the auxiliary transistor comprises a plurality of auxiliary transistors in series with one another and having respective gate terminals shorted to one another.

6. The circuit according to any of claims 1-5, further comprising a plurality of resistors in series with one another such that:

the gate terminal of the switch transistor is coupled to a gate node of the circuit through the plurality of resistors; and
the gate terminal of the switch transistor is coupled, through at least one but less than all of the plurality of resistors, to whichever of the source terminal of the auxiliary transistor or the drain terminal of the auxiliary transistor that is not coupled to the body terminal of the switch transistor.

7. The circuit according to any of claims 1-5, further comprising a first resistor and a second resistor in parallel to one another such that:

the first resistor couples the gate terminal of the switch transistor to a gate node of the circuit, and;
the second resistor couples the gate terminal of the switch transistor to whichever of the source terminal of the auxiliary transistor or the drain terminal of the auxiliary transistor that is not shorted to the body terminal of the switch transistor.

8. The circuit according to any of claims 1-7, wherein the circuit is disposed on a silicon-on-insulator chip within a mobile radio device.

9. The circuit according to claim 8, wherein the chip is a radio-frequency front end chip.

10. A method of designing a circuit, comprising:

determining a maximum harmonic distortion over a prescribed range of input voltages;
for a circuit comprising a switch transistor and an auxiliary transistor in which a body terminal of the switch transistor is coupled to a source terminal of the auxiliary transistor or a drain terminal of the auxiliary transistor, designing an impedance to couple a gate terminal of the auxiliary transistor to a source terminal of the switch transistor or a drain terminal of the switch transistor such that for any input voltage within the prescribed range, output voltage from the switch transistor does not exceed the determined maximum harmonic distortion; and implementing the circuit with the designed impedance in at least one of a circuit diagram or a silicon-on-insulator chip.

11. The method according to claim 10, wherein the designed impedance is a shorted connection between the gate terminal of the auxiliary transistor and the source terminal of the switch transistor or drain terminal of the switch transistor.

12. The method according to claim 10 or 11, in which:

the prescribed range of input voltages is a predefined range of at least one of transmit voltage $V_{TX}$ and receive voltage $V_{RX}$ for a radio; and
the maximum harmonic distortion over the prescribed range of gate voltages is required for a radio, in which the circuit is implemented within an antenna switch thereof, to comply with specifications of a radio access technology.

13. The method according to any of claims 10-12, in which the maximum harmonic distortion includes second order harmonic distortion and third order harmonic distortion.

14. A circuit comprising:

a switch transistor having a gate terminal, a source terminal, a drain terminal and a body terminal; and

an auxiliary transistor having a gate terminal, a source terminal, and a drain terminal; wherein

the body terminal of the switch transistor is coupled to one of the source terminal of the auxiliary transistor or the drain terminal of the auxiliary transistor; and the gate terminal of the auxiliary transistor is coupled to a node of the switch transistor; wherein an impedance coupling the gate terminal of the auxiliary transistor to the source terminal of the switch transistor or the drain terminal of the switch transistor yields, for any input voltage within a prescribed range, an output voltage from the switch transistor that is within an allowed maximum harmonic distortion.

15. The circuit according to claim 14 wherein the gate terminal of the auxiliary transistor is shorted to the source terminal of the switch transistor or the drain terminal of the switch transistor.

104

104A

101B

101D

101S

102S

101G

102G

102

102B

101

102D

105

106

**FIG. 1A**

204

201

202

**FIG. 2:
Prior Art**

FIG. 1C

FIG. 1B

**FIG. 3:**

**Test Circuit**

**FIG. 4**

**FIG. 5**

**FIG. 6**

FIG. 7

| PROG, 10C | |
| --- | --- |
| MEM, 10B | Radio 10D |
| DP, 10A | UE, 10 |

10E

14

| PROG, 12C | |
| --- | --- |
| MEM, 12B | Radio 12D |
| DP, 12A | access node, 12 |

12E

**FIG. 8**

Europäisches
Patentamt

European
Patent Office

Office européen
des brevets

# EUROPEAN SEARCH REPORT

Application Number

EP 15 18 4391

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2015/070075 A1 (KEANE JOHN [IE]) 12 March 2015 (2015-03-12) * paragraphs [0002], [0003], [0052], [0089]; figures 2, 11, 15 * | 1-6,8-15 | INV. H01L27/12 H03K17/687 H03K17/16 |
| X | US 4 529 897 A (SUZUKI YASOJI [JP] ET AL) 16 July 1985 (1985-07-16) * figures 6, 7, 9-26 * | 1-4,14, 15 | |
| Y | | 7 | |
| Y | US 2014/009209 A1 (CEBI HAKI [US] ET AL) 9 January 2014 (2014-01-09) * paragraph [0076]; figure 9 * | 7 | |

| | | | TECHNICAL FIELDS SEARCHED (IPC) |
|---|---|---|---|
| | | | H01L H03K |

The present search report has been drawn up for all claims

| Place of search | Date of completion of the search | Examiner |
|---|---|---|
| Munich | 11 February 2016 | Seck, Martin |

EPO FORM 1503 03.82 (P04C01)

## ANNEX TO THE EUROPEAN SEARCH REPORT
### ON EUROPEAN PATENT APPLICATION NO.

EP 15 18 4391

This annex lists the patent family members relating to the patent documents cited in the above-mentioned European search report.
The members are as contained in the European Patent Office EDP file on
The European Patent Office is in no way liable for these particulars which are merely given for the purpose of information.

11-02-2016

| Patent document cited in search report | | Publication date | Patent family member(s) | | Publication date |
|---|---|---|---|---|---|
| US 2015070075 | A1 | 12-03-2015 | NONE | | |
| US 4529897 | A | 16-07-1985 | DE | 3226339 A1 | 03-02-1983 |
| | | | FR | 2509931 A1 | 21-01-1983 |
| | | | US | 4529897 A | 16-07-1985 |
| US 2014009209 | A1 | 09-01-2014 | NONE | | |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20150015321 A
- US 8829967 B
- US 8129787 B
- US 8954902 B